# EUROPEAN PATENT SPECIFICATION

(11) **EP 3 809 589 B1**
(45) Date of publication and mention of the grant of the patent: **26.07.2023**
(21) Application number: 19203436.1
(22) Date of filing: 15.10.2019
(51) Int. Cl.: H01L 31/048, H02S 20/25, F24S 25/67, E04D 3/36, E04D 1/36, E04D 3/38

(54) **ARRAY OF PHOTOVOLTAIC PANELS INCORPORATING SEALING ASSEMBLY**
ANORDNUNG VON PHOTOVOLTAISCHEN PLATTEN MIT DER DICHTUNGSANORDNUNG
RÉSEAU DE PANNEAUX PHOTOVOLTAÏQUES COMPRENANT L'ENSEMBLE D'ÉTANCHÉITÉ

(43) Date of publication of application: 21.04.2021
(73) Proprietor: R&MS Solutionpartner Verwaltungs GmbH, 8017 Strassen (LU)
(72) Inventor: MACK, Reiner, 56477 Waigandshain (DE); GIESSLER, Bernd, 56477 Waigandshain (DE)
(74) Representative: de Rooij, Mathieu Julien

(56) References cited:
- EP-A1- 2 679 929
- EP-A2- 0 531 869
- WO-A2-2010/128375
- DE-U1- 29 809 280
- DE-U1-202008 009 241

## Description

The present disclosure relates to a sealing assembly. More particularly, the present disclosure relates to a sealing assembly arranged between two photovoltaic panels. The present disclosure furthermore relates to an array of photovoltaic panels incorporating such a sealing assembly and to a roof structure comprising such an array.

### BACKGROUND

An ever-growing energy demand has made it necessary to consider solutions coming from renewable energy sources for the production of energy. Energy from water and air flows, biomass and sun are some of the most promising of such sources.

Photovoltaic (PV) cells are electrical devices that convert the energy of light directly into electricity by the photovoltaic effect. PV cells are typically arranged in modules that comprise a plurality of photovoltaic cells. Such modules are called solar panels. Arrays of panels are typically used to generate enough electricity that would be meaningful to store in batteries or to directly power electricity consuming devices. However, such arrays may use a lot of space, which cannot otherwise be used. For example, it is known to place large arrays of photovoltaic panels in fields or to place a single panel or a smaller array of panels on top of buildings.

Roofs of houses and buildings are attractive places for positioning PV panels or modules, because they receive a lot of sun light. It is known to use PV or "solar" roof tiles to cover part of a roof of a building. Such solar roof tiles perform the function of a traditional roof tile, but at the same time can produce electricity through energy conversion of solar rays. Just as traditional roof tiles, the solar roof tiles are to be connected to a framework of a roof, and they protect the underlying structure from weather influences, and particularly they keep rain out.

The existing solar roof tiles suffer from various drawbacks. Existing solar roof tiles may be complicated to install. The process of placing the solar roof tiles can therefore be cumbersome and require a long time. Also, since solar roof tiles are made from more fragile materials, it frequently happens that the solar roof tiles are damaged during installation. This can affect the functioning of the photovoltaic cells, it may lead to leaks, and it can be aesthetically unpleasing. Furthermore, it needs to be ensured that even in strong winds or storms, the roof tiles stay in place. This represents another important requirement for roof tiles, which has not always been met by existing solar roof tiles.

US 2018/0166600 describes a photovoltaic module employing an array of photovoltaic cells disposed between two optically transparent substrates such as to a defined closed-loop peripheral area of the module that does not contain a photovoltaic cell. The module is sealed with a peripheral seal along the perimeter. The two substrates may be laterally offset with respect to each other.

Further improvements in PV roof tiles are still desired.

### SUMMARY

In a first aspect, the present disclosure provides a seal assembly for arrangement between a first and a second photovoltaic panel. The first and the second photovoltaic panel have a first side edge, and a second side edge opposite to the first side edge, and comprise an upper layer and a lower layer, wherein the upper layer is offset with respect to the lower layer at the first and second side edges, such that the upper layer of the first photovoltaic panel at its second side edge partially overlaps the lower layer of the second photovoltaic panel at its first side edge. The seal assembly comprises an upper abutment part for abutting the upper layers of the first and second photovoltaic panels, a lower abutment part for abutting the lower layers of the first and second photovoltaic panel, and an intermediate part connecting the upper abutment part with the lower abutment part and configured for being arranged between the upper layer of the first photovoltaic panel and the lower layer of the second photovoltaic panel.

In accordance with this aspect, a seal assembly is provided which enables easier installation of photovoltaic panels. The photovoltaic panels have offset layers, and the seal assembly is adapted to these offset layers, such that a photovoltaic panel can be laid, a seal can be laid against the panel and partly on top of it, and the subsequent panel can be laid. The process can be faster than in prior art solutions because there is no separate process for sealing after laying. The risk of damaging the photovoltaic panels is reduced because the sealing assembly can avoid the more fragile parts of the panels touching each other.

In some examples, a top edge of the upper abutment part of the sealing assembly may be substantially level with a top surface of the first photovoltaic panel and a top surface of the second photovoltaic panel. If the top surfaces of the photovoltaic panels are level or "flush" with the sealing, no dirt, dust, and moist can accumulate against the sides of the sealing or between the photovoltaic panels. Not only can aesthetics be improved in this way, but also the functioning of the panels, and maintenance needs may be reduced.

In some examples, a lower edge of the intermediate part may comprise a plurality of protrusions to form a labyrinth seal. Leaks of water may be avoided or reduced in this manner.

In another aspect, an array of photovoltaic panels comprising a first photovoltaic panel and a second photovoltaic panel is provided. The photovoltaic panels have a first side edge, and a second side edge opposite to the first side edge, and an upper layer and a lower layer, wherein the upper layer is offset with respect to the lower layer at the first and second side edges, such that the upper layer of the first photovoltaic panel partially overlaps the lower layer of the second photovoltaic panel. The array further comprises the seal assembly according to any of the examples herein disclosed, arranged between the first and second photovoltaic panels.

In yet a further aspect, a roof structure for a building comprising a supporting framework, and the array of photovoltaic panels according to any of the herein disclosed examples is provided.

### BRIEF DESCRIPTION OF THE DRAWINGS

Particular implementations will be described in the following by way of non-limiting examples, with reference to the appended drawings, in which:
Figures 1A and 1b illustrate an exploded view of an example of a roof structure according to the present disclosure;
Figures 2A and 2B illustrate cross-sectional views of an array of photovoltaic panels and a sealing assembly according to an example of the present disclosure; and
Figures 3A and 3B schematically illustrates an example of a build-up of a roof structure.

### DETAILED DESCRIPTION OF EMBODIMENTS

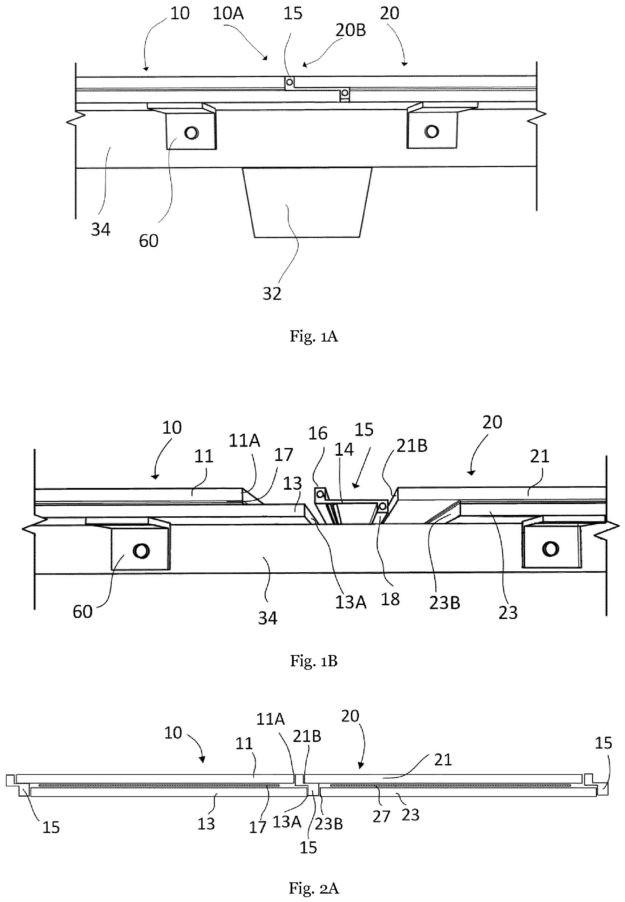

Figure 1 illustrates an example of part of a roof structure. Figure 1A shows a side view of an assembly whereas figure 1B shows an exploded of the various components of the assembly.

The roof structure according to this example includes a framework supporting photovoltaic panels. The photovoltaic panels of this example function as solar roof tiles. The photovoltaic panels 10, 20 comprise photovoltaic cells. These cells can be irradiated by the sun during the day and the cells are configured to convert solar energy into electricity. Electrical power generated by the photovoltaic panels may be used for electrical consumption in a household living under the roof structure. Additionally, or alternatively, the electrical power may be directed towards an energy storage such as a battery for later consumption. Additionally, or alternatively, the electrical power may be provided to the electrical grid.

At the same, the photovoltaic panels may function as roof tiles, i.e. they protect the inside of a building under the roof structure from the weather, particularly rain. Appropriate sealing between the photovoltaic panels is therefore important.

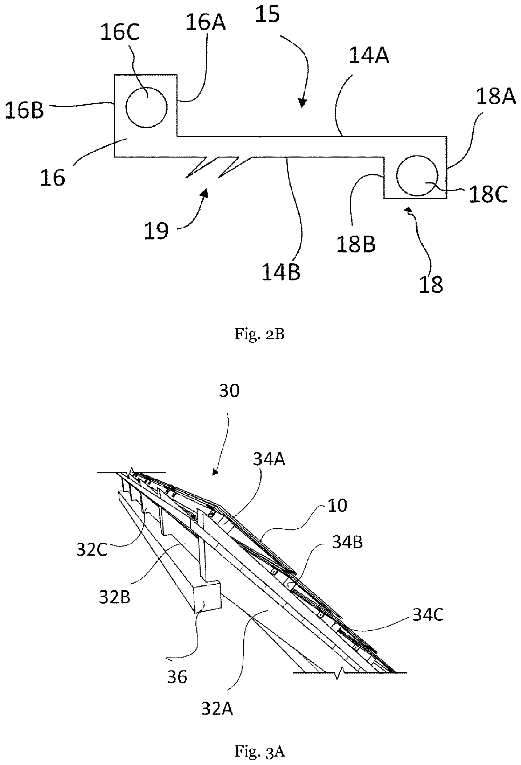

In the example of figure 1, a supportive framework is provided. The supportive framework may include a plurality of horizontal beams 34 and vertical beams 32. The horizontal beams 34 are supported by a plurality of vertical beams 32, which extend between a base and a top. In this particular example, the beams may be wooden beams. Horizontal beams extend substantially horizontally, whereas vertical beams may have a slope of e.g. 10 - 45° with respect to a horizontal place. This may be seen e.g. in figure 3A. Even though the beams are herein referred to as vertical beams, they clearly are not to be understood as arranged entirely vertically in use.

A first photovoltaic panel 10 is shown to be arranged next to a second photovoltaic panel 20. The photovoltaic panels 10, 20 may be attached to the horizontal beams 34 using a mounting bracket, or ankle plate 60. The mounting bracket may be bolted to beams 34 and attached to a photovoltaic panel using e.g. an adhesive. In other examples, different attachment systems may be used involving e.g. clamps for clamping the photovoltaic panels.

Each of the photovoltaic panels 10, 20 comprises an upper layer 11, and a lower layer 13. In between the upper layer 11 and lower layer 13, one or more PV cells 17 may be arranged. Each panel may comprise a plurality of interconnected PV cells.

It may be seen that the upper layers of the PV panels are offset with respect to the lower layers. The upper layer 11, 21 is offset with respect to the lower layer 13, 23 at the first and second side edges, such that the upper layer 21 of the first photovoltaic panel 10 at its second side edge partially overlaps the lower layer 13 of the second photovoltaic panel 10 at its first side edge.

This will be illustrated in more detail in subsequent figures. The offset between the upper layers and lower layers means that at a first edge 20B of the photovoltaic panel 20, the upper layer of photovoltaic panel 20 overlaps the lower layer of adjacent photovoltaic panel 10. At the opposite edge (not shown) of photovoltaic panel 20, its bottom layer may be arranged underneath an upper layer of a further adjacent photovoltaic panel.

In figure 1, a sealing assembly 15 may be seen to be arranged between photovoltaic panel 10 and photovoltaic panel 20. It may be seen that the seal assembly 15 comprises an upper abutment part 16 for abutting the upper layers 11, 21 of the first 20 and second photovoltaic panels 10, and a lower abutment part 18 for abutting the lower layers 13, 23 of the first 20 and second photovoltaic panel 10. The seal assembly further comprises an intermediate part 14 connecting the upper abutment part 16 with the lower abutment part 18 and configured for being arranged between the upper layer 21 of the first photovoltaic panel 20 and the lower layer 13 of the second photovoltaic panel 10.

More particularly, in this example, the upper abutment part 16 is arranged between first side edge 21B of upper layer 21 of panel 20, and second side edge 11A of the upper layer 11 of solar panel 10. And lower abutment part 18 is arranged between second side edge 13A of lower layer 13 of solar panel 10 and first side edge 23B of lower layer 23 of solar panel 20.

More details will be illustrated with reference to figures 2A and 2B.

Figures 2A and 2B illustrate cross-sectional views of an array of photovoltaic panels and sealing assemblies according to an example of the present disclosure arranged between neighboring photovoltaic panels. Figures 2A and 2B illustrate a seal assembly 15 for arrangement between a first 20 and a second photovoltaic panel 10, the first 20 and the second photovoltaic panel 10 having a first side edge, and a second side edge opposite to the first side edge, and comprising an upper layer 11, 21 and a lower layer 13, 23. It may be seen that the same seal assembly may be arranged at opposite ends of the shown photovoltaic panels.

Figure 2B shows how in this example the upper abutment part 16 comprises a first side surface 16A for contacting a first side edge 21B of the upper layer 21 of photovoltaic panel 20. The upper abutment part in this example further comprises a second side surface 16B for contacting a second side edge 11A of the upper layer 11 of photovoltaic panel 10.

Similarly, the lower abutment part may comprise a first surface 18A for contacting a first side edge 23B of the lower layer 23 of photovoltaic panel 20, and a second side surface 18B for contacting a second side edge 13A of the lower layer 13 of photovoltaic panel 10.

Intermediate part 14 connects the abutment portion 16 with abutment portion 18. The intermediate part may have a top surface 14A arranged to enter into contact with upper layer 21 of photovoltaic panel 20 and a bottom surface 14B configured to enter into contact with lower layer 13 of photovoltaic panel 10.

Even though these explanations are only given for one side edge, where upper layer 23 of photovoltaic panel 20 overlaps with lower layer 11 of photovoltaic panel 10, it should be clear that a similar seal assembly 15 may be arranged at the opposite edge of photovoltaic panel 20, and also at the opposite side edge of photovoltaic panel 10, and at side edges of subsequent photovoltaic panels in a row.

As shown, a top edge of the upper abutment part is substantially level with a top surface of the first photovoltaic panel 20 and a top surface of the second photovoltaic panel 10. By arranging the upper abutment part 16 flush with the photovoltaic panels, accumulation of dirt, moist, dust, leaves and other against the sealing assembly 15 or in between panels 10, 20 may be avoided. Growth of moss can be avoided in this manner. This can reduce the need for cleaning and maintenance and can even lead to an increase in electrical power generation and/or an increase in the life expectancy of the photovoltaic panels.

The height of the upper abutment part may substantially correspond to the thickness of the upper layer 11, 21 of the photovoltaic panels. A thickness of the intermediate part 14 may generally correspond to the thickness or gap between the upper and lower layers of the solar panels. A height of the lower abutment part 18 may be shorter than the thickness of the lower layers 13, 23 of the photovoltaic panels. The material usage may be reduced by making these lower abutment parts slightly shorter, and to perform their function and avoid damage between panels it is not necessary to extend to the lower edge of the panels.

As may be seen in figure 2B, a lower edge 14B of the intermediate part 14 may comprise a plurality of protrusions to form a labyrinth seal 19. A labyrinth seal is a seal that provides a tortuous path to prevent leakage, and in this particular example, the seal is arranged to prevent rainwater from dripping to underneath the roof structure. It should be clear that the number of protrusions of a labyrinth seal may be varied.

It may also bee seen that the upper abutment part 16 and/or the lower abutment part 18 may comprise a structural member 16C, 18C. The main body of the sealing assembly 15 including upper abutment part, intermediate part and lower abutment part may be made e.g. from an elastomer, rubber or silicon material. Such materials may also include elements to increase strength and/or stiffness like glass fibers or carbon fibers. In an example, to increase strength and stiffness, the upper abutment part and/or lower abutment part may comprise e.g. a rod or bar of a stiff polymer or metal. Providing relatively stiff upper and lower abutment parts may increase ease of handle for operators that have to lay the seal.

In some examples, the sealing assembly may be provided on a roll and suitable lengths may be cut off as needed for a specific array of panels. In other examples, the sealing assembly is provided and delivered of a specific length corresponding to the width of the panels for which it is to be used.

In some examples, the upper layer 11, 21 of the first and second photovoltaic panels 10, 20 may comprise a glass plate. Such a glass plate serves to provide structural strength and rigidity to the panels. The glass plate further protects the PV cells from hail or impact of objects. In some non-illustrated examples, the photovoltaic panels may comprise a frame, such as an aluminum frame.

In some examples, the lower layer 13, 23 of the first and second photovoltaic panels may comprise a solar back sheet.

In some examples, the first and the second photovoltaic panels may comprise a plurality of photovoltaic cells 17, 27 encapsulated in a polymer matrix. The photovoltaic cells may be crystalline cells, but other types of cells could be used. The polymer matrix may be formed by or may comprise Ethylene-vinyl acetate (EVA).

In some examples, the active layer (i.e. in this example the encapsulated photovoltaic cells) may be arranged between the upper and the lower layer. The separation of layers as illustrated herein may facilitate manufacture of the panels.

In some examples, a length of the seal assembly may be larger than a length of the first side edge of the first and second photovoltaic panels. Depending on the structure, a plurality of panels may be laid side by side, then a sealing assembly may be placed extending along the first side edge of the plurality of panels. Then subsequent panels may be placed against the sealing assembly.

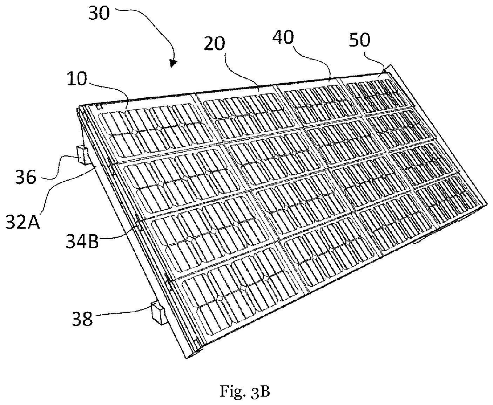

In some examples, the first and second photovoltaic panels may further comprise a third side edge and a fourth side edge opposite to the third side edge, wherein the upper layer and the lower layer of the first photovoltaic panel and second photovoltaic panel at the third and fourth side edges are not offset. In roof structures, a lower edge (e.g. third edge) of photovoltaic panels of a higher row may overlap an upper portion (at the fourth edge) of the lower row of panels. This may be seen e.g. in figure 3.

In other examples, the photovoltaic panels may also have an offset at the third and fourth side edges. In such cases, similar seal assemblies may be arranged between photovoltaic panels at the third and fourth side edges.

Figure 3 schematically illustrates an example of a build-up of a roof structure. The roof structure of this example comprises a supporting framework, and an array of photovoltaic panels. The photovoltaic panels or photovoltaic roof tiles may include a plurality of rows. In a top row, photovoltaic panels 10, 20, 40 and 50 are shown.

The supporting framework in this example comprises a top beam 36, a bottom 38, a plurality of vertical beams 32A, 32B, etc. extending between the top beam 36 and the bottom beam, and a plurality of horizontal beams 34A, 34B, 34C etc. which are arranged substantially in parallel with the top beam and the bottom beam.

The first and second photovoltaic panels 10, 20 may be attached to one or more of the beams of the supporting framework, specifically the first and second photovoltaic panels 10, 20 may be attached to one of the horizontal beams 34A, 34B etc. More specifically, the photovoltaic panels may substantially span the distance between neighboring horizontal beams 34. In some examples, the photovoltaic panels may be secured to two horizontal beams.

One method of securing the photovoltaic panels to the beams was illustrated in figure 1. The first and second photovoltaic panels may be attached to one of the beams of the supporting framework with one or more metal brackets. Attachment of the panels may include clamps, adhesives, screws, or combinations hereof. Because of the partial overlapping of neighboring panels in a row, they also provide support to each other.

It may be seen in figures 3A and 3B, that a bottom edge of a higher row of panels (e.g. the top row comprising panels, 10, 20, 40, 50) overlaps an upper edge of a lower row of panels. It may be seen however that the active material i.e. the photovoltaic cells are not covered by neighboring panels.

With the techniques and arrangements disclosed herein, entire roofs or parts of roofs may be covered with solar roof tiles in an efficient, aesthetically pleasing and cost-effective manner.

Although only a number of particular embodiments and examples of the invention have been disclosed herein, it will be understood by those skilled in the art that other alternative embodiments and/or uses of the invention and obvious modifications and equivalents thereof are possible. Furthermore, the present invention covers all possible combinations of the particular embodiments described. Thus, the scope of the present invention should not be limited by particular embodiments, but should be determined only by a fair reading of the claims that follow.

## Claims

1. An array of photovoltaic panels (10, 20) comprising a first photovoltaic panel (20) and a second photovoltaic panel (10) having a first side edge, and a second side edge opposite to the first side edge, wherein
the first (20) and the second (10) photovoltaic panels have an upper layer (21; 11) and a lower layer (23; 13), wherein
the upper layer (21; 11) is offset with respect to the lower layer (23; 13) at the first and second side edges, such that the upper layer (21) of the first photovoltaic panel (20) partially overlaps the lower layer (13) of the second photovoltaic panel (10), and the array **characterized in that** the array further comprises
a seal assembly (15) for arrangement between the first (20) and second (10) photovoltaic panels, wherein the seal assembly (15) comprises:
an upper abutment part (16) for abutting the upper layers (21; 11) of the first and second photovoltaic panels,
**characterized in that** the seal assembly (15) further comprises:
a lower abutment part (18) for abutting the lower layers (23; 13) of the first and second photovoltaic panel, and
an intermediate part (14) connecting the upper abutment part (16) with the lower abutment part (18) and configured for being arranged between the upper layer (21) of the first photovoltaic panel (20) and the lower layer (13) of the second photovoltaic panel (10)

2. The array of photovoltaic panels according to claim 1, wherein a top edge of the upper abutment part (16) of the seal assembly (15) is substantially level with a top surface of the first photovoltaic panel (20) and a top surface of the second photovoltaic panel (10).

3. The array of photovoltaic panels according to claim 1 or 2, wherein a lower edge (14B) of the intermediate part (14) of the seal assembly (15) comprises a plurality of protrusions (19) to form a labyrinth seal.

4. The array of photovoltaic panels according to claim 1 -3, wherein a length of the seal assembly (15) is larger than a length of the first side edge of the first and second photovoltaic panels (20; 10).

5. The array of photovoltaic panels according to claim 1-4, wherein the first and second photovoltaic panels (20; 10) further comprise a third side edge and a fourth side edge opposite to the third side edge, wherein
the upper layer (21) and the lower layer (23) of the first photovoltaic panel (20) at the third and fourth side edges are not offset, and wherein
the upper layer (11) and the lower layer (13) of the second photovoltaic panel (10) at the third and fourth side edges are not offset.

6. The array of photovoltaic panels according to any of claims 1 - 5, wherein the upper layer (21; 11) of the first and second photovoltaic panels comprises a glass plate.

7. The array of photovoltaic panels according to any of claims 1 - 6, wherein the lower layer (23; 13) of the first and second photovoltaic panels comprise a solar back sheet.

8. The array of photovoltaic panels according to any of claims 1 - 7, wherein the first and the second photovoltaic panels comprise a plurality of photovoltaic cells (17) encapsulated in a polymer matrix.

9. The array of photovoltaic panels according to claim 8, wherein the photovoltaic cells (17) are crystalline cells.

10. The array of photovoltaic panels according to claim 8 or 9, wherein the polymer matrix comprises Ethylene-vinyl acetate (EVA).

11. The array of photovoltaic panels according to any of claims 8 - 10, wherein the encapsulated photovoltaic cells (17) are arranged between the upper (21; 11) and the lower layer (23; 13).

12. A roof structure for a building comprising
a supporting framework, and
the array of photovoltaic panels (10, 20, 40, 50)according to any of claims 1 - 11.

13. The roof structure according to claim 12, wherein the supporting framework comprises a top beam (36), a bottom beam (38), a plurality of vertical beams (32A, 32B, 32C) extending between the top beam (36) and the bottom beam (38), and a plurality of lateral beams (34A, 34B) which are arranged substantially in parallel with the top beam (36) and the bottom beam (38), and
wherein the first and second photovoltaic panels are attached to one or more of the beams of the supporting framework, specifically
wherein the first and second photovoltaic panels are attached to one of the lateral beams.

14. The roof structure according to claim 13, wherein the first and second photovoltaic panels are attached to one of the beams of the supporting framework with one or more metal brackets.

## Patentansprüche

1. Anordnung von Photovoltaikpaneelen (10, 20), die ein erstes Photovoltaikpaneel (20) und ein zweites Photovoltaikpaneel (10) mit einer ersten Seitenkante und einer zweiten Seitenkante gegenüber der ersten Seitenkante umfasst, wobei
das erste (20) und das zweite (10) Photovoltaikpaneel eine obere Schicht (21; 11) und eine untere Schicht (23; 13) aufweisen, wobei
die obere Schicht (21; 11) in Bezug auf die untere Schicht (23; 13) an den ersten und zweiten Seitenkanten versetzt ist, so dass die obere Schicht (21) des ersten Photovoltaikpaneels (20) die untere Schicht (13) des zweiten Photovoltaikpaneels (10) teilweise überlappt, und die Anordnung **dadurch gekennzeichnet ist, dass** die Anordnung weiterhin
eine Dichtungsanordnung (15) zur Anordnung zwischen dem ersten (20) und dem zweiten (10) Photovoltaikpaneel umfasst, wobei die Dichtungsanordnung (15) Folgendes umfasst:
ein oberes Anschlagteil (16) zum Anschlagen der oberen Schichten (21; 11) der ersten und zweiten Photovoltaikpaneele,
**dadurch gekennzeichnet, dass** die Dichtungsanordnung (15) ferner umfasst:
ein unteres Anschlagteil (18) zum Anschlagen der unteren Schichten (23; 13) der ersten und zweiten Photovoltaikpaneele, und
ein Zwischenteil (14), das das obere Anschlagteil (16) mit dem unteren Anschlagteil (18) verbindet und so konfiguriert ist, dass es zwischen der oberen Schicht (21) des ersten Photovoltaik Paneels (20) und der unteren Schicht (13) des zweiten Photovoltaik Paneels (10) angeordnet wird.

2. Die Anordnung von Photovoltaikpaneelen nach Anspruch 1, wobei eine Oberkante des oberen Anschlagteils (16) der Dichtungsanordnung (15) im Wesentlichen auf gleicher Höhe mit einer oberen Fläche des ersten Photovoltaikpaneels (20) und einer oberen Fläche des zweiten Photovoltaikpaneels (10) liegt.

3. Die Anordnung von Photovoltaikpaneelen nach Anspruch 1 oder 2, wobei eine untere Kante (14B) des Zwischenteils (14) der Dichtungsanordnung (15) eine Vielzahl von Vorsprüngen (19) zur Bildung einer Labyrinthdichtung aufweist.

4. Die Anordnung von Photovoltaikpaneelen nach einem der Ansprüche 1 bis 3, wobei die Länge der Dichtungsanordnung (15) größer als die Länge der ersten Seitenkante der ersten und zweiten Photovoltaikpaneele (20; 10) ist.

5. Die Anordnung von Photovoltaikpaneelen nach einem der Ansprüche 1 bis 4, wobei die ersten und zweiten Photovoltaikpaneele (20; 10) ferner eine dritte Seitenkante und eine vierte Seitenkante gegenüber der dritten Seitenkante aufweisen, wobei
die obere Schicht (21) und die untere Schicht (23) des ersten Photovoltaikpaneels (20) an der dritten und vierten Seitenkante nicht versetzt sind, und wobei
die obere Schicht (11) und die untere Schicht (13) des zweiten Photovoltaikpaneels (10) an der dritten und vierten Seitenkante nicht versetzt sind.

6. Die Anordnung von Photovoltaikpaneelen nach einem der Ansprüche 1 bis 5, wobei die obere Schicht (21; 11) der ersten und zweiten Photovoltaikpaneele eine Glasplatte umfasst.

7. Die Anordnung von Photovoltaikpaneelen nach einem der Ansprüche 1 bis 6, wobei die untere Schicht (23; 13) der ersten und zweiten Photovoltaikpaneele eine Solarrückwandfolie umfasst.

8. Die Anordnung von Photovoltaikpaneelen nach einem der Ansprüche 1 bis 7, wobei die erste und zweite Photovoltaikpaneele eine Vielzahl von Photovoltaikzellen (17) umfassen, die in einer Polymermatrix eingekapselt sind.

9. Die Anordnung von Photovoltaikpaneelen nach Anspruch 8, wobei die Photovoltaikzellen (17) kristalline Zellen sind.

10. Die Anordnung von Photovoltaikpaneelen nach Anspruch 8 oder 9, wobei die Polymermatrix Ethylen-Vinylacetat (EVA) umfasst.

11. Die Anordnung von Photovoltaikpaneelen nach einem der Ansprüche 8 bis 10, wobei die eingekapselten Photovoltaikzellen (17) zwischen der oberen (21; 11) und der unteren Schicht (23; 13) angeordnet sind.

12. Eine Dachkonstruktion für ein Gebäude, bestehend aus
einen unterstützenden Rahmen und
die Anordnung von Photovoltaik Paneelen (10, 20, 40, 50) nach einem der Ansprüche 1 bis 11.

13. Die Dachkonstruktion nach Anspruch 12, wobei der unterstützende Rahmen einen oberen Balken (36), einen unteren Balken (38), eine Vielzahl von vertikalen Balken (32A, 32B, 32C), die sich zwischen dem oberen Balken (36) und dem unteren Balken (38) erstrecken, und eine Vielzahl von seitlichen Balken (34A, 34B) umfasst, die im Wesentlichen parallel zu dem oberen Balken (36) und dem unteren Balken (38) angeordnet sind, und
wobei das erste und das zweite Photovoltaikpaneel an einem oder mehreren Trägern des Tragwerks befestigt sind, insbesondere
wobei das erste und das zweite Photovoltaikpaneel an einem der seitlichen Balken befestigt sind.

14. Die Dachkonstruktion nach Anspruch 13, wobei das erste und das zweite Photovoltaikpaneel an einem des Rahmens mit einer oder mehreren Metallklammern befestigt sind.

## Revendications

1. Réseau de panneaux photovoltaïques (10, 20) comprenant un premier panneau photovoltaïque (20) et un second panneau photovoltaïque (10) ayant un premier bord latéral et un second bord latéral opposé au premier bord latéral, dans lequel
le premier (20) et le second (10) panneaux photovoltaïques ont une couche supérieure (21; 11) et une couche inférieure (23 ; 13), dans lesquels
la couche supérieure (21 ; 11) est décalée par rapport à la couche inférieure (23 ; 13) au niveau des premier et deuxième bords latéraux, de sorte que la couche supérieure (21) du premier panneau photovoltaïque (20) recouvre partiellement la couche inférieure (13) du second panneau photovoltaïque (10), et **caractérisé en ce que** le réseau comprend en outre
un ensemble de joints (15) à placer entre le premier (20) et le second (10) panneaux photovoltaïques, dans lequel l'ensemble de joints (15) comprend :
une partie supérieure de butée (16) pour buter les couches supérieures (21; 11) du premier et du second panneau photovoltaïque,
**caractérisé par le fait que** l'ensemble de joint (15) comprend en outre :
une partie de butée inférieure (18) pour buter les couches inférieures (23 ; 13) du premier et du second panneau photovoltaïque, et
une partie intermédiaire (14) reliant la partie de butée supérieure (16) à la partie de butée inférieure (18) et configurée pour être disposée entre la couche supérieure (21) du premier panneau photovoltaïque (20) et la couche inférieure (13) du second panneau photovoltaïque (10)

2. Réseau de panneaux photovoltaïques selon la revendication 1, dans lequel un bord supérieur de la partie supérieure (16) de l'ensemble de joint (15) est sensiblement au même niveau qu'une surface supérieure du premier panneau photovoltaïque (20) et qu'une surface supérieure du second panneau photovoltaïque (10).

3. Réseau de panneaux photovoltaïques selon la revendication 1 ou 2, dans lequel un bord inférieur (14B) de la partie intermédiaire (14) de l'ensemble de joint (15) comprend une pluralité de protubérances (19) pour former un joint labyrinthe.

4. Réseau de panneaux photovoltaïques selon les revendications 1 à 3, dans lequel la longueur de l'ensemble de joint (15) est supérieure à la longueur du premier bord latéral des premier et deuxième panneaux photovoltaïques (20 ; 10).

5. Réseau de panneaux photovoltaïques selon les revendications 1 à 4, dans lequel les premier et deuxième panneaux photovoltaïques (20 ; 10) comprennent en outre un troisième bord latéral et un quatrième bord latéral opposé au troisième bord latéral, dans lequel
la couche supérieure (21) et la couche inférieure (23) du premier panneau photovoltaïque (20) au niveau des troisième et quatrième bords latéraux ne sont pas décalées, et dans lequel
la couche supérieure (11) et la couche inférieure (13) du deuxième panneau photovoltaïque (10) au niveau des troisième et quatrième bords latéraux ne sont pas décalées.

6. Réseau de panneaux photovoltaïques selon l'une des revendications 1 à 5, dans lequel la couche supérieure (21; 11) du premier et du deuxième panneau photovoltaïque comprend une plaque de verre.

7. Réseau de panneaux photovoltaïques selon l'une des revendications 1 à 6, dans lequel la couche inférieure (23; 13) du premier et du second panneau photovoltaïque comprend une feuille solaire dorsale.

8. Réseau de panneaux photovoltaïques selon l'une des revendications 1 à 7, dans lequel les premier et second panneaux photovoltaïques comprennent une pluralité de cellules photovoltaïques (17) encapsulées dans une matrice polymère.

9. Réseau de panneaux photovoltaïques selon la revendication 8, dans lequel les cellules photovoltaïques (17) sont des cellules cristallines.

10. Réseau de panneaux photovoltaïques selon la revendication 8 ou 9, dans lequel la matrice polymère comprend de l'éthylène-acétate de vinyle (EVA).

11. Réseau de panneaux photovoltaïques selon l'une des revendications 8 à 10, dans lequel les cellules photovoltaïques encapsulées (17) sont disposées entre la couche supérieure (21 ; 11) et la couche inférieure (23 ; 13).

12. Une structure de toit pour un bâtiment comprenant
un cadre d'appui, et
le réseau de panneaux photovoltaïques (10, 20, 40, 50) selon l'une des revendications 1 à 11.

13. La structure de toit selon la revendication 12, dans laquelle le cadre d'appui comprend une poutre supérieure (36), une poutre inférieure (38), une pluralité de poutres verticales (32A, 32B, 32C) s'étendant entre la poutre supérieure (36) et la poutre inférieure (38), et une pluralité de poutres latérales (34A, 34B) qui sont disposées sensiblement parallèlement à la poutre supérieure (36) et à la poutre inférieure (38), et
dans lequel les premier et second panneaux photovoltaïques sont fixés à une ou plusieurs des poutres de la structure de support, en particulier
dans lequel les premier et second panneaux photovoltaïques sont fixés à l'une des poutres latérales.

14. La structure de toit selon la revendication 13, dans laquelle les premier et second panneaux photovoltaïques sont fixés à l'une des poutres du cadre d'appui à l'aide d'un ou de plusieurs supports métalliques.
